# EUROPÄISCHE PATENTSCHRIFT

(11) **EP 1 654 602 B1**
(45) Veröffentlichungstag und Bekanntmachung des Hinweises auf die Patenterteilung: **03.12.2008**
(21) Anmeldenummer: 04763753.3
(22) Anmeldetag: 03.08.2004
(51) Int. Cl.: G05B 19/35

(54) **VERFAHREN UND SCHALTUNGSANORDNUNG ZUR PRÄ ZISEN, DYNAMISCHEN DIGITALEN ANSTEUERUNG VON INSBESONDERE PIEZOAKTOREN FÜR MIKRPOSITIONIERSYSTEME**
METHOD AND CIRCUIT ARRANGEMENT FOR THE PRECISE, DYNAMIC DIGITAL CONTROL OF ESPECIALLY PIEZOELECTRIC ACTUATORS FOR MICROPOSITIONING SYSTEMS
PROCEDE ET MONTAGE POUR REALISER LA COMMANDE NUMERIQUE, DYNAMIQUE ET PRECISE EN PARTICULIER D'ACTIONNEURS PIEZO-ELECTRIQUES DESTINES A DES SYSTEMES DE MICROPOSITIONNEMENT

(30) Priorität: 11.08.2003 DE 10336820
(43) Veröffentlichungstag der Anmeldung: 10.05.2006
(73) Patentinhaber: Physik Instrumente (PI) GmbH & Co. KG, 76228 Karlsruhe (DE)
(72) Erfinder: GEYER, Bernhard, 76137 Karlsruhe (DE); BESCH, Berthold, 76137 Karlsruhe (DE); JORDAN, Scott, San Jose, CA 95120 (US)
(74) Vertreter: Kruspig, Volkmar
(86) Internationale Anmeldenummer: PCT/EP2004/008695
(87) Internationale Veröffentlichungsnummer: WO 2005/017634

(56) Entgegenhaltungen:
- DE-C1- 19 923 462
- US-B1- 6 308 106

## Beschreibung

Die Erfindung betrifft ein Verfahren sowie eine Schaltungsanordung zur präzisen, dynamischen digitalen Ansteuerung von insbesondere Piezoaktoren für Mikropositioniersysteme mit einem Regler, vorzugsweise PID-Regler, wobei zur Minimierung von Positions-Folge-Abweichungen das zukünftige Systemverhalten abgeschätzt und aktuelle Korrektursignale im Sinne einer Feedforward-Korrektur gewonnen werden, gemäß Oberbegriff des Patentanspruchs 1 bzw. 11.

Feedforward-Regelungen gehören zum bekannten Stand der Technik.

Bei PID-Reglern bzw. PID-Algorithmen gibt es nur dann ein Korrektursignal, wenn eine Regelabweichung existiert. Dies bedeutet, dass grundsätzlich von Positions-Folge-Fehlern auszugehen ist. Ziel einer Feedforward-Regelung ist die Minimierung dieser Positions-Folge-Fehler. Mit einer Feedforward-Regelung wird das zukünftige Systemverhalten abgeschätzt und die aktuellen Korrektursignale werden dementsprechend gesetzt. Die Korrekturen erfolgen im Allgemeinen durch die Multiplikation der notwendigen Geschwindigkeiten mit dem Geschwindigkeits-Feedforward-Verstärkungsfaktor. Eine ähnliche Methode kann genutzt werden, um eine Beschleunigungs-Feedforward-Korrektur durchzuführen. Auf diese Weise lässt sich der Positions-Folge-Fehler bei Beschleunigungen und Abbremsungen von z.B. Aktorsystemen reduzieren.

Feedforward-Regelungsprinzipien finden beispielsweise Anwendung zum Positionieren eines magnetoresistiven Kopfes gemäß DE 696 06 784 T2, zur Kompensation der akustischen Rückkopplung bei einem System zur aktiven Geräuschminderung nach DE 195 05 610 A1, bei der Giersteuerung für Drehflügel-Flugzeuge gemäß DE 692 05 173 T2 und in anderen Gebieten der Technik.

Weiterhin bekannt sind Positioniervorrichtungen mit einem insbesondere einen Piezokeramik-Aktor aufweisenden Positionierantrieb, einem Positionssensor und einer eingangsseitig mit einer Steuersignal-Eingabeeinrichtung sowie in einer geschlossenen Regelschleife mit dem Positionssensor verbundenen Antriebssteuereinrichtung für den Positionierantrieb, die zur Ausgabe vorgeformter Ansteuersignale an den Positionierantrieb ausgebildet ist. Eine solche bekannte Positioniervorrichtung gemäß DE 199 23 462 C2 weist ein steuerbares Filter mit veränderbaren Filterkoeffizienten auf, das über einen Steuereingang mit einer Filterkoeffizienten-Berechnungseinheit verbunden ist, welche über einen ersten Eingang mit der Steuersignal-Eingabeeinrichtung und über einen zweiten Eingang mindestens mit dem Positionssensor verbunden ist und aus den eingegebenen Sollpositions-Steuersignalen sowie erfassten Ist-Positionssignalen in Echtzeit die aktuellen, neuen Filterkoeffizienten berechnet. Diese Positioniervorrichtung kann in besonders flexibler Weise auf geänderte Systembedingungen reagieren.

Aus Untersuchungen, zurückgehend auf die Anmelderin, hat es sich gezeigt, dass Feedforward-Systeme in analogen Steuerungen, z.B. zum Betreiben von Piezoaktoren im wesentlichen problemlos realisiert werden können. Schwierigkeiten entstehen jedoch dann, wenn eine digitale Steuerung realisiert werden soll, da die Abtastung prinzipielle Latenzzeiten erzeugt, die den an sich gegebenen dynamischen Vorteil des Feedforward-Zweigs stark einschränken. Darüber hinaus existieren bei bekannten digitalen Steuergeräten weitere Wartezeiten, zum Teil auch mit variablen Längen, so dass für hochdynamische Anwendungen primär auf analoge Regelungen zurückgegriffen wurde.

Der Oberbegriff des Anspruchs 1 wird in US-6308106 veröffentlicht:

Mit dem bekannten Stand der Technik ist es daher bisher nicht möglich, die Dynamik schneller Piezoaktoren mit den Vorteilen digitaler Systeme, wie höhere Präzision, Wiederholbarkeit, Austauschbarkeit und Flexibilität zu verbinden.

Aus dem Vorgenannten ist es daher Aufgabe der Erfindung, ein Verfahren sowie eine Schaltungsanordnung zur präzisen, dynamischen digitalen Ansteuerung von insbesondere Piezoaktoren für Mikropositioniersysteme anzugeben, wobei die bekannten Vorteile von Feedforward-Zweigen nutzbar sind, ohne dass wesentliche Einschränkungen bei hochdynamischen Steuerungsanforderungen an das System bestehen.

Die Lösung der Aufgabe der Erfindung erfolgt verfahrensseitig mit einer Lehre gemäß Definition des Patentanspruchs 1 sowie bezogen auf die Schaltungsanordnung mit der Merkmalskombination nach Patentanspruch 11, wobei die Unteransprüche mindestens zweckmäßige Ausgestaltungen und Weiterbildungen darstellen.

Der Grundgedanke der Erfindung besteht darin, einen vom eigentlichen Abtastregelkreis unabhängigen, quasi zweiten Signalpfad vorzusehen. Hierdurch kann eine schnelle digitale Feedforward-Steuerung durch Bypassing des eigentlichen Abtastsystems realisiert werden. Mit anderen Worten gelingt es, die Latenzzeit im Feedforward-Zweig des Abtastsystems zu reduzieren, indem primär über die Führungsgröße die Feedforward-Strecke und einen schnellen Digital-Analog-Wandler eine Steuerung des Piezoaktors erfolgt und sekundär die Regelstrecke mit Positionssensor zur Vermeidung von statischen Fehlern untergeordnet betrieben wird.

Mit dem Verfahren sowie der Schaltungsanordnung gemäß der Erfindung gelingt es, eine digitale, Ein- oder Mehrachsen-Hochgeschwindigkeits-Steuerung von Piezoaktoren anzugeben, wobei sich der schaltungstechnische Aufwand in geringen Grenzen hält und die vorteilhafte Möglichkeit besteht, durch programmtechnische Vorgabe von verschiedenen Parametern Veränderungen von Filtereigenschaften in der Schaltungsanordnung vorzunehmen, so dass auch eine kundenseitige Optimierung an die jeweilige Anwendungsaufgabe möglich wird.

Zur Reduzierung der Latenzzeiten im Feedforward-Zweig des Abtastsystems wird das Signal der Führungsgröße mittels eines digitalen Interface über einen schaltbaren Bypass auf den vorerwähnten Digital-Analog-Wandler höchster Auflösung geführt, wobei dieser Digital-Analog-Wandler mit der Abtastrate des Abtastsystems zu betreiben ist.

Weiterhin führt die Feedforward-Strecke auf einen zweiten, schnellen Digital-Analog-Wandler, welcher abtastsystemunabhängig angesteuert wird. Die Steuerspannungen repräsentierenden Ausgangssignale der Wandler werden dann addiert der anzusteuernden Einrichtung, insbesondere dem Piezoaktor zugeführt, welcher mit einem Positionssensor die eigentliche Regelstrecke bildet.

Ergänzend besteht die Möglichkeit der Vornahme einer Gewichtung und/oder Filterung der dem schnellen Digital-Analog-Wandler zugeleiteten Signale.

Sowohl der schnelle, erste Digital-Analog-Wandler der Steuerstrecke als auch der hochauflösende, zweite Digital-Analog-Wandler der Regelstrecke kann mit derselben Führungsgröße beaufschlagt werden. Der zweite Digital-Analog-Wandler ist demnach auf die Regeleigenschaften, insbesondere auf höchste Auflösung optimiert, wobei der erste Digital-Analog-Wandler auf kürzestmögliche Latenzzeit gerichtet ist und die Ansteuerung dieses schnellen Wandlers unabhängig vom Abtastsystem betrieben wird, so dass dadurch kein Jitter auftritt.

Die optionale Gewichtung und/oder Filterung der dem schnellen Wandler zugeführten Signale kann in Abhängigkeit von den Streckeneigenschaften vorgenommen werden.

Ebenso liegt es im Sinne der Erfindung, eine Linearisierung der Regelstrecke vorzunehmen, um systematische Fehler in den Signalwegen zu vermeiden. Zum Zwecke des Reduzierens von möglichen Streckenresonanzen kann in einer Ausführungsform der Erfindung eine gezielte Vorverzerrung der Steuerspannungen und/oder eine Anordnung von Sperrfiltern erfolgen.

Schalteinrichtungen und/oder Steuerkommandos ermöglichen es, Führungsgrößenänderungen sowohl auf den ersten, schnellen Digital-Analog-Wandler, den zweiten, hochpräzisen Wandler oder beide Wandler zu leiten. Über weitere Schalteinrichtungen sind wahlweise auch verschiedene Führungsgrößen abrufbar.

Über die Schalteinrichtungen können Filter- und/oder Gewichtsfunktionen für die Führungsgröße der Steuer- und/oder Regelstrecke aktiviert werden.

Anstelle zwei diskreter, jeweils auf die gewünschten Eigenschaften optimierter Wandler besteht ebenso die Möglichkeit, einen einzigen Digital-Analog-Wandler einzusetzen, welcher umschaltbare oder optimierte Funktionalitäten bezüglich der Auflösung bzw. Schnelligkeit besitzt.

Beim Grundprinzip der Schaltungsanordnung zur präzisen, dynamischen digitalen Ansteuerung von insbesondere Piezoaktoren für Mikropositioniersysteme ist der Führungsgrößen-Eingang über ein digitales Interface auf den Feedforward-Steuerzweig und auf einen Vergleicher gelegt. Das digitale Interface ist bevorzugt zum parallelen Datentransfer geeignet und als PIO (Parallel-Input-Output) ausgeführt.

Am Vergleichereingang des Vergleichers liegt das digitale Ausgangssignal der Positionssensor-Abtast-Regelstrecke an.

Der Vergleicherausgang steht mit einem Additionsglied in Verbindung, an dessen weiterem Eingang der Feedforward-Steuerzweig angeschlossen ist.

Letztendlich führt der Ausgang des Additionsglieds auf einen Digital-Analog-Wandler, welcher das Steuersignal für den Aktor, insbesondere Piezoaktor an seinem Ausgang bereitstellt.

Alternativ kann der Vergleicherausgang auf den Eingang eines hochauflösenden Digital-Analog-Wandlers führen, dessen Ausgang mit dem ersten Eingang des Additionsglieds in Verbindung steht, sowie der Feedforward-Steuerzweig auf den Eingang eines schnellen Digital-Analog-Wandlers führen, dessen Ausgang mit dem zweiten Eingang des Additionsglieds in Verbindung steht, um primär über die Führungsgröße die Feedforward-Strecke und den schnellen Digital-Analog-Wandler den Aktor zu steuern und sekundär die Regelstrecke mit Positionssensor zur Vermeidung von statischen Fehlern untergeordnet zu betreiben.

Zwischen einem Leistungsverstärker zum Ansteuern des Piezoaktors und dem Ausgang des Additionsglieds kann in einer weiteren Ausgestaltung der Erfindung ein einstellbares Notch-Filter vorgesehen sein, welches wahlweise auch überbrückbar ist.

Die erfindungsgemäße Schaltungsanordnung besteht demnach aus den Baugruppen zur Erfassung der Sensorpositionen, der Baugruppe zur digitalen Sensorsignalverarbeitung mittels eines DSPs (digitaler Signalprozessor), dem Piezoverstärker einschließlich der vorbeschriebenen D-A-Wandler und einem digitalen, insbesondere PIO-Interface.

Bei einer Ausführungsform der Erfindung ist der erste, schnelle Digital-Analog-Wandler als 16-Bit- und der hochauflösende Wandler als ein solcher mit 20-Bit-Auflösung gewählt. Der schnelle Wandler ist unmittelbar über das PIO-Interface ansteuerbar, wobei zur Ansteuerung des hochauflösenden Wandlers eine weitere, serielle Schnittstelle vorgesehen ist.

Bei der Positionserfassung des Piezoaktors wird von einer Sensoranordnung ausgegangen, welche die mechanische Bewegung bzw. mechanische Position in analoge Spannungen umsetzt. Im Regelfall ist die erhaltene analoge Spannung proportional den Positionsänderungen. Ein Analog-Digital-Wandler transferiert die analogen Spannungen in ein digitales Signal, die gegebenenfalls einer Lowpass-Filterung und einer Linearisierung unterzogen werden und dann auf den Vergleichseingang des Vergleichers führen, wodurch sich ein geschlossener Kreis (Feedback-Loop) ergibt.

Alles in allem gelingt es mit der vorgestellten Erfindung, ein Verfahren sowie eine neuartige Schaltungsanordnung zur präzisen, dynamischen digitalen Ansteuerung von insbesondere Piezoaktoren für Mikropositioniersysteme anzugeben, welches bzw. welche minimale Latenzzeiten im Bereich von 2 bis 5 µs realisiert, so dass die Dynamik schneller Piezoaktoren mit der gewünschten digitalen Ansteuerung vereinbar ist. Dadurch, dass primär die Führungsgröße als Steuerung arbeitet, fällt der Regelung die Hauptaufgabe zu, den unvermeidbaren statischen Fehler zu reduzieren. Durch eine variable Kommandostruktur kann jede Führungsgrößenänderung entweder auf den schnellen Digital-Analog-Wandler, den hochauflösenden Wandler bzw. die Servoregelung oder aber auch auf beide Signalwege geführt werden.

Die Erfindung soll anhand eines Ausführungsbeispiels sowie unter Zuhilfenahme von Figuren näher erläutert werden.

Hierbei zeigen:
- Fig. 1: eine prinzipielle Darstellung der Grundfunktionen der Schaltungsanordnung getastet - ungetastet (sampled - unsampled) und
- Fig. 2: eine Detaildarstellung der Schaltungsanordnung mit zwei speziellen, hinsichtlich ihrer Funktionen optimierten Digital-Analog-Wandler.

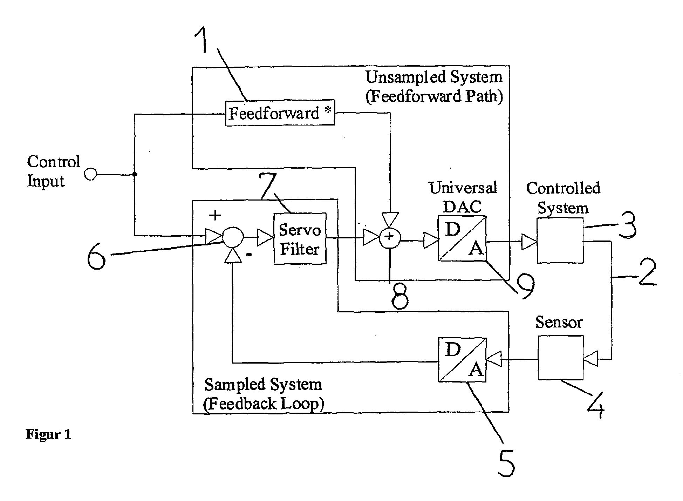

Gemäß Fig. 1 wird von einem Feedforward-Zweig 1 und einer Regelstrecke 2 ausgegangen.

Die Regelstrecke 2 enthält das anzusteuernde System 3, z.B. einen Piezoaktor, und weist darüber hinaus einen Wegsensor 4 auf. Zur Regelstrecke 2 gehört ein ausgangsseitig des Wegsensors 4 angeschlossener Analog-Digital-Wandler 5.

Dieser Analog-Digital-Wandler 5 führt auf einen Eingang eines Vergleichers 6, dessen Ausgang über ein optionales Servofilter 7 auf den ersten Eingang eines Addierers 8 führt. Am zweiten Eingang dieses Addierers 8 liegt das Ausgangssignal des Feedforward-Zweigs bzw. eines Feedforward-Filters an.

Der Ausgang des Addierers 8 führt auf einen universellen Digital-Analog-Wandler 9, welcher sowohl hochauflösend als auch hochdynamisch betreibbar ist. Dieser universelle Digital-Analog-Wandler 9 stellt dann das analoge Ausgangssignal für den Piezoaktor 3 zur Verfügung. Zum Treiben des Piezoaktors 3 sind selbstverständlich noch geeignete Verstärker notwendig, die in der Fig. 1 aus Vereinfachungsgründen nicht gezeigt sind.

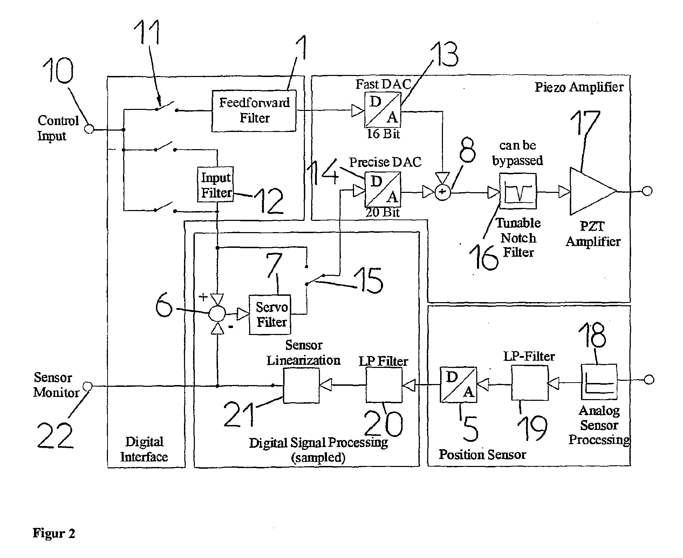

Gemäß der detaillierteren Darstellung der Schaltungsanordnung nach Fig. 2 ist der Führungsgrößeneingang 10 über Schalteinrichtungen 11 sowohl mit dem Feedforward-Zweig 1 als auch über ein Eingangsfilter 12 mit der Regelstrecke in Verbindung stehend. Der Führungsgrößeneingang 10 ist hier als digitales Interface ausführbar, und zwar in einer PIO und seriellen Interface-Konfiguration, z.B. einer RS 232-Schnittstelle.

Ausgangsseitig ist der Feedforward-Zweig 1 auf einen ersten, schnellen Digital-Analog-Wandler 13 geführt, dessen Ausgang auf den zweiten Eingang des Vergleichers 8 führt. Die Regelstrecke, d.h. der Ausgang des Servorfilters 7, wiederum führt auf den Eingang eines hochauflösenden Digital-Analog-Wandlers 14, dessen Ausgang auf den ersten Eingang des Vergleichers 8 gelangt. Zur wahlweisen Beaufschlagung auch des Digitaleingangs des Wandlers 14 ist eine Umschalteinrichtung 15 vorgesehen.

Am Ausgang des Vergleichers 8 befindet sich ein durchstimmbares Notch-Filter 16, das wiederum mit einem Verstärker 17 in Verbindung steht, dessen Ausgang auf das figürlich nicht dargestellte PZT-Element, nämlich einen Piezoaktor führt.

Der Wegsensor 4 führt über einen entsprechenden Eingang auf eine Signalverarbeitungseinheit 18, welcher ein Bandpassfilter 19 und der Analog-Digital-Wandler 5 nachgeordnet ist. Die digitale Signalverarbeitungseinheit der Regelstrecke umfasst ein weiteres Bandpassfilter 20 und eine Anordnung zur Linearisierung der Sensorsignale 21. Der Ausgang dieser Einheit 21 steht mit dem Vergleichseingang des Vergleichers 6 in Verbindung und liefert darüber hinaus ein Sensormonitoringsignal an einen hierfür vorgesehenen Ausgang 22.

Mit der vorstehend anhand der Figuren beschriebenen Schaltungsanordnung ist es möglich, sowohl den ersten, schnellen Digital-Analog-Wandler der Steuerstrecke als auch den zweiten, hochauflösenden Digital-Analog-Wandler der Regelstrecke mit ein und derselben Führungsgröße zu beaufschlagen, wobei eine Linearisierung der Regelstrecke zum Zweck der Vermeidung systematischer Fehler in den Signalwegen erfolgen kann.

Die Schaltungsanordnung ist so betreibbar, dass primär über die Führungsgröße die Feedforward-Strecke und den ersten, schnellen Digital-Analog-Wandler eine Steuerung des Piezoaktors erfolgt, wobei sekundär die Regelstrecke mit Positionssensor zur Vermeidung von statischen Fehlern untergeordnet in Funktion tritt.

Bei der Darstellung nach Fig. 1 wird davon ausgegangen, dass ein einziger Digital-Analog-Wandler zum Einsatz kommt, welcher z.B. in umschaltbarer Weise verschiedene Funktionalitäten bezüglich der geforderten Auflösung und Schnelligkeit besitzt.

### Bezugszeichenliste

- 1: Feedforward-Zweig
- 2: Regelstrecke
- 3: Piezoaktor
- 4: Wegsensor
- 5: Analog-Digital-Wandler
- 6: Vergleicher
- 7: Servofilter
- 8: Addierer bzw. Addierglied
- 9: universeller Digital-Analog-Wandler
- 10: Führungsgrößen-Eingang
- 11: Schalteinrichtungen
- 12: Eingangsfilter
- 13: schneller Digital-Analog-Wandler
- 14: hochauflösender Digital-Analog-Wandler
- 15: Umschalteinrichtung
- 16: durchstimmbares Notch-Filter
- 17: PZT-Verstärker
- 18: analoge Sensorsignalverarbeitungseinheit
- 19; 20: Bandpassfilter
- 21: Einrichtung zur Linearisierung der Sensorsignale
- 22: Sensormonitoringausgang

## Patentansprüche

1. Verfahren zur präzisen, dynamischen digitalen Ansteuerung von insbesondere Piezoaktoren für Mikropositioniersysteme mit einem PID-Regler, wobei zur Minimierung von Positions-Folge-Abweichungen das zukünftige Systemverhalten abgeschätzt und aktuelle Korrektursignale im Sinne einer Feed-Forward-Korrektur gewonnen werden,
**dadurch gekennzeichnet, dass**
zur Reduzierung von Latenzzeiten im Feed-Forward-Zweig des Abtastsystems das Signal der Führungsgröße über einen schaltbaren Bypass auf einen ersten Digital-Analog-Wandler höchster Auflösung gelangt, wobei dieser erste Digital-Analog-Wandler mit der Abtastrate des Abtastsystems betrieben wird, weiterhin die PID-Feed-Forward-Strecke auf einen zweiten, schnellen Digital-Analog-Wandler führt, welcher abtastsystemunabhängig angesteuert wird und die Steuerspannungen repräsentierenden Ausgangssignale des ersten und zweiten Wandlers addiert zur anzusteuernden Einrichtung, insbesondere einem Piezoaktor gelangen, welcher mit einem Positionssensor die Regelstrecke bildet.

2. Verfahren nach Anspruch 1,
**dadurch gekennzeichnet, dass**
eine Gewichtung und/oder Filterung der dem ersten Digital-Analog-Wandler zugeleiteten Signale der Führungsgröße vorgenommen wird.

3. Verfahren nach Anspruch 1,
**dadurch gekennzeichnet, dass**
sowohl der erste, schnelle Digital-Analog-Wandler der Steuerstrecke als auch der zweite, hochauflösende Digital-Analog-Wandler der Regelstrecke mit derselben Führungsgröße beaufschlagt werden.

4. Verfahren nach einem der vorangegangenen Ansprüche,
**gekennzeichnet durch**
eine Linearisierung der Regelstrecke zum Zweck der Vermeidung systematischer Fehler in den Signalwegen.

5. Verfahren nach einem der vorangegangenen Ansprüche,
**gekennzeichnet durch**
gezielte Vorverzerrung der Steuerspannungen und/oder Anordnung von Sperrfiltern zum Zweck des Reduzierens von Streckenresonanzen.

6. Verfahren nach einem der vorangegangenen Ansprüche,
**dadurch gekennzeichnet, dass**
primär über die Führungsgröße die Feed-Forward-Strecke und den ersten, schnellen Digital-Analog-Wandler der Piezoaktor gesteuert betrieben wird, wobei sekundär die Regelstrecke mit Positionssensor zur Vermeidung von statischen Fehlern untergeordnet betrieben ist.

7. Verfahren nach einem der vorangegangenen Ansprüche,
**dadurch gekennzeichnet, dass**
über Schalteinrichtungen und/oder Steuerkommandos Führungsgrößenänderungen sowohl auf den ersten, schnellen Digital-Analog-Wandler, den zweiten, hochpräzisen Wandler oder beide Wandler geleitet werden können.

8. Verfahren nach einem der vorangegangenen Ansprüche,
**dadurch gekennzeichnet, dass**
über eine weitere Schalteinrichtung wahlweise verschiedene Führungsgrößen abrufbar sind.

## Claims

1. A method for the precise dynamic digital control of especially piezoelectric actuators for micropositioning systems, comprising a PID regulator, whereby in order to minimise position order deviations the future system behaviour is estimated and current correction signals are obtained for the purpose of a feedforward correction,
**characterised in that**
for the reduction of latency times in the feedforward loop of the sampling system, the signal of the command is applied via a switchable bypass to a first digital/analog converter of highest resolution, with this first digital/analog converter being operated at the sampling rate of the sampling system,
the PID feedforward loop further leads to a second fast digital/analog converter which is controlled independent of the sampling system, and
the output signals of the first and second converter, which represent control voltages, are supplied in an added-up form to the device to be controlled, in particular, to a piezoelectric actuator which together with a position sensor forms the controlled system.

2. The method in accordance with Claim 1,
**characterised in that**
a weighting and/or filtering of the signals of the command variable, which are supplied to the first digital/analog converter is carried out.

3. The method in accordance with Claim 1,
**characterised in that**
the same command variable is applied to both the first fast digital/analog converter of the controlled system and the second high-resolution digital/analog converter of the controlled system.

4. The method in accordance with one of the previous claims,
**characterised by**
a linearisation of the controlled system for the purpose of avoiding systematic errors in the signal paths.

5. The method in accordance with one of the previous claims,
**characterised by**
a specific predistorion of the control voltages and/or the arrangement of band elimination filters for the purpose of reducing system resonances.

6. The method in accordance with one of the previous claims,
**characterised in that**
the piezoelectric actuator is primarily operated in a controlled manner via the command variable, the feedforward loop, and the first fast digital/analog converter, while secondarily the controlled system with position sensor is operated in a subordinate manner in order to avoid static errors.

7. The method in accordance with one of the previous claims,
**characterised in that**
changes of the command variable may be provided both to the first fast digital/analog converter, the second high-precision converter, or to both converters via switch means and/or control commands.

8. The method in accordance with one of the previous claims,
**characterised in that**
various command variables may be fetched selectively via a further switch means.

## Revendications

1. Procédé pour le pilotage numérique dynamique précis en particulier d'actionneurs piézoélectriques destinés à des systèmes de micro-positionnement, comportant un régulateur PID, dans lequel, en vue de minimiser des écarts de suivi de position, on estime le futur comportement du système et on obtient des signaux de correction actuels dans le sens d'une correction "Feed-Forward",
**caractérisé en ce que**
pour réduire des temps de latence dans la branche Feed-Forward du système d'échantillonnage, le signal de la grandeur pilote parvient via un by-pass commutable vers un premier convertisseur numérique-analogique à résolution maximale, ce premier convertisseur numérique-analogique travaillant à la cadence d'échantillonnage du système d'échantillonnage, l'unité PID-Feed-Forward mène en outre vers un second convertisseur numérique-analogique rapide qui est piloté indépendamment du système d'échantillonnage, et les signaux de sortie, représentant des tensions de commande, du premier et du second convertisseur parviennent après addition vers le dispositif à piloter, en particulier vers un actionneur piézo-électrique qui constitue l'unité de régulation conjointement avec un capteur de position.

2. Procédé selon la revendication 1,
**caractérisé en ce que**
l'on réalise une pondération et/ou un filtrage des signaux de la grandeur pilote amenés au premier convertisseur numérique-analogique.

3. Procédé selon la revendication 1,
**caractérisé en ce que**
aussi bien le premier convertisseur numérique-analogique rapide de l'unité de commande que le second convertisseur numérique-analogique à haute résolution de l'unité de régulation sont sollicités par la même grandeur pilote.

4. Procédé selon l'une des revendications précédentes,
**caractérisé par**
une linéarisation de l'unité de régulation en vue d'éviter des erreurs systématiques dans les chemins des signaux.

5. Procédé selon l'une des revendications précédentes,
**caractérisé par**
une prédistorsion ciblée des tensions de commande et/ou par l'agencement de filtres de coupe en vue de réduire les résonances en circuit.

6. Procédé selon l'une des revendications précédentes,
**caractérisé en ce que**
l'on fait fonctionner l'actionneur piézo-électrique sous commande en premier lieu via la grandeur pilote de l'unité Feed-Forward et via le premier convertisseur numérique-analogique rapide, en faisant fonctionner l'unité de régulation avec le capteur de position en second lieu de façon subordonnée en vue d'éviter des erreurs statiques.

7. Procédé selon l'une des revendications précédentes,
**caractérisé en ce que**
au moyen de dispositifs de commutation et/ou des ordres de commande, on peut appliquer des modifications de grandeur pilote aussi bien au premier convertisseur numérique-analogique rapide, qu'au second convertisseur à haute résolution ou bien aux deux convertisseurs.

8. Procédé selon l'une des revendications précédentes,
**caractérisé en ce que**
l'on peut interroger au choix différentes grandeurs pilotes via un autre dispositif de commutation.
